Europäisches Patentamt

European Patent Office

Office européen des brevets

(19)

(11)  EP 0 626 763 B1

(12)  EUROPEAN PATENT SPECIFICATION

(45) Date of publication and mention
of the grant of the patent:
**13.10.1999  Bulletin 1999/41**

(51) Int Cl.$^6$: **H03M 1/00**

(21) Application number: **94108145.7**

(22) Date of filing: **26.05.1994**

(54) **Method and apparatus for converting an analog signal to a digital floating-point number and a digital floating-pont number to an analog signal**

Verfahren und Vorrichtung zur Umsetzung eines analogen Signal in einer Gleitkommazahl und einer Gleitkommazahl in einem analogen Signal

Procédé et appareil de conversion d'un signal analogique en un nombre à virgule flottante et d'un nombre à virgule flottante en un signal analogique

(84) Designated Contracting States:
**DE ES FR GB IT NL SE**

(30) Priority: **26.05.1993 FI 932400**

(43) Date of publication of application:
**30.11.1994  Bulletin 1994/48**

(73) Proprietor: **OY NOKIA AB**
**00130 Helsinki (FI)**

(72) Inventors:
• **Neuvo, Yrjö**
**SF-33720 Tampere (FI)**
• **Gabbouj Moncef**
**FIN-33720 Tampere (FI)**
• **Kalliojärvi, Kari**
**SF-33720 Tampere (FI)**
• **Vainio, Olli**
**SF-33720 Tampere (FI)**
• **Kontro, Jarmo**
**SF-33720 Tampere (FI)**

(74) Representative:
**Körber, Wolfhart, Dr. rer.nat. et al**
**Patentanwälte**
**Mitscherlich & Partner,**
**Sonnenstrasse 33**
**80331 München (DE)**

(56) References cited:
**US-A- 4 720 809**

• **PROCEEDINGS OF VLSI AND COMPUTER PERIPHERALS, HAMBURG, MAY 8 - 12, 1989, IEEE COMPUTER SOCIETY PRESS, pages 3-129-132, XP000044165 WOLFFENBUTTEL R F: "NONLINEAR AD CONVERTERS FOR INTEGRATED SILICON OPTICAL SENSORS"**

**Description**

The invention relates to a method and apparatus for converting an analog signal to a digital floating-point number and a digital floating-point number to an analog signal.

The use of floating-point arithmetic is rapidly becoming more general in digital signal processing. The reason for this is that the advantages achieved with floating-point arithmetic over conventionally used fixed-point arithmetic are now recognized. These advantages include a wide dynamic range in floating-point representation and the fact that in floating-point arithmetic, the signal-to-noise ratio (SNR), which is used as a measure of error, is a constant that is independent of the level of the signal processed. The use of floating-point arithmetic in digital signal processing is much enhanced by the fact that efficient and sufficiently inexpensive floating-point signal processors are generally available. Almost all present floating-point processors comply with the binary floating-point standard established by the Institute of Electrical and Electronics Engineers (IEEE), which facilitates the connection of processors with other units of digital signal processing systems. Floating-point arithmetic or its derivatives are now used in various applications, e.g. in the television stereo sound standard NICAM and the high definition television standards MAC, DigiCipher and MUSE, in which floating-point representation is used in transmission of audio information.

The connection of a digital signal processing system with an existing environment is implemented by analog/digital (A/D) and digital/analog (D/A) converters. Conventionally, A/D and D/A converters are implemented by fixed-point arithmetic, in which the quantization steps are of a constant magnitude. Converters implemented by fixed-point arithmetic are nowadays relatively inexpensive and generally available. However, the performance and properties of fixed-point converters are not completely suitable for all applications of signal processing. In these applications, better results can be obtained by using signal sampling, in which the quantization step is not constant.

By utilizing floating-point arithmetic, which is the best known number representation with a variable quantization step, in A/D and D/A converters, the performance of the converters can be improved, particularly if the dynamic range of the signal processed is great or the relative proportion of low signal levels is great. Thereby conversions can be performed with a great accuracy within a dynamic range that is wide in respect of the word length in use. Floating-point converters enable the implementation of an entire floating-point signal processing chain, in which the advantages achieved with floating-point arithmetic are not lost in any part of the signal processing chain.

Conventionally, a floating-point A/D converter is implemented by an adjustable amplifier and a fixed-point A/D converter, as presented e.g. in U.S. Patent 4,584,560. The drawback of this structure is that its analog unit is complicated and the converter is slow because of the settling of the adjustable amplifier, which requires time.

Correspondingly, a floating-point D/A converter can be implemented by an adjustable amplifier and a fixed-point D/A converter. A D/A converter of this structure has the same drawbacks as presented above in connection with an A/D converter. Further, non-continuity in the output of an adjustable amplifier may cause audible errors e.g. in audio applications.

The invention relates to a method and apparatus for floating-point A/D conversion on the one hand and to a method and apparatus for floating-point D/A conversion on the other hand, the object being to eliminate the above drawbacks. The method according to the invention for converting an analog signal to a digital floating-point number (floating-point A/D conversion) is characterized by

- forming a logarithmed signal from an analog signal by a logarithmic function having an arbitrary base and multiplying the signal by a compensating constant coefficient if the base of said logarithmic function is other than 2;
- converting the resultant signal to digital form by fixed-point A/D conversion;
- separating the exponent of the floating-point number from the digitized sample value and calculating the mantissa of the floating-point number from the fractional part by a base 2 exponential function;
- forming a digital floating-point number by adding the mantissa and the exponent.

The method according to the invention for converting a digital floating-point number to an analog signal is characterized by

- converting the mantissa of the floating-point number by a logarithmic function having an arbitrary base to the exponent of the base and multiplying the exponent by a compensating constant coefficient if the base of said logarithmic function is other than 2;
- adding the thus converted mantissa and exponent;
- converting the digital number obtained to an analog signal by fixed-point D/A conversion and forming from the converted signal a signal that represents its base 2 exponent.

In the conversion methods according to the invention the object has been that the complexity of the converter structures is implemented by digital technology, whereby it is much easier to control and easier to implement. The analog units of the structure are fixedly biased and are thus more reliable than the analog units of conventional structures with variable bias values. By the conversion methods according to the invention, floating-point conversions can be carried out more reliably and by converters that have a less complex structure (and are therefore less expensive) than in the conventional solutions. The conversion methods can also be easily modified in accordance with the requirements set by different kinds of applications since this can be done by changing the digital unit only.

Logarithmic or exponential non-linearity has previously been used in connection with A/D and D/A converters for compressing the dynamic range of the signal to be converted. The new idea introduced by the present invention is that if base 2 logarithmic and exponential functions are used as non-linearities, a floating-point converter can be implemented by performing simple operations on digital samples.

The advantageous embodiments of the methods and apparatuses according to the invention are characterized by what is stated below in the attached claims.

In the following, embodiments of known floating-point converters are presented with reference to Figs. 1 to 3, in which

Fig. 1 shows the relative accuracy of number representation as a function of the absolute magnitude of the number in significant bits,

Fig. 2 shows a known floating-point A/D converter implemented by an adjustable amplifier and a fixed-point A/D converter,

Fig. 3 shows a known a floating-point D/A converter implemented by an adjustable amplifier and a fixed-point D/A converter.

In floating-point arithmetic a number can be written as

$$X = sign(X)\, m\, 2^c \tag{1}$$

where sign(X) is the sign of the number, m is the mantissa and c is the exponent. The definition of the exponent is

$$c = \lfloor \log_2 |x| \rfloor + 1 \tag{2}$$

where $\lfloor . \rfloor$ is a floor function, which converts the result to an integer that is smaller than or equal to the argument of the function. When the exponent is defined in this manner, the mantissa is in the range [0.5,1].

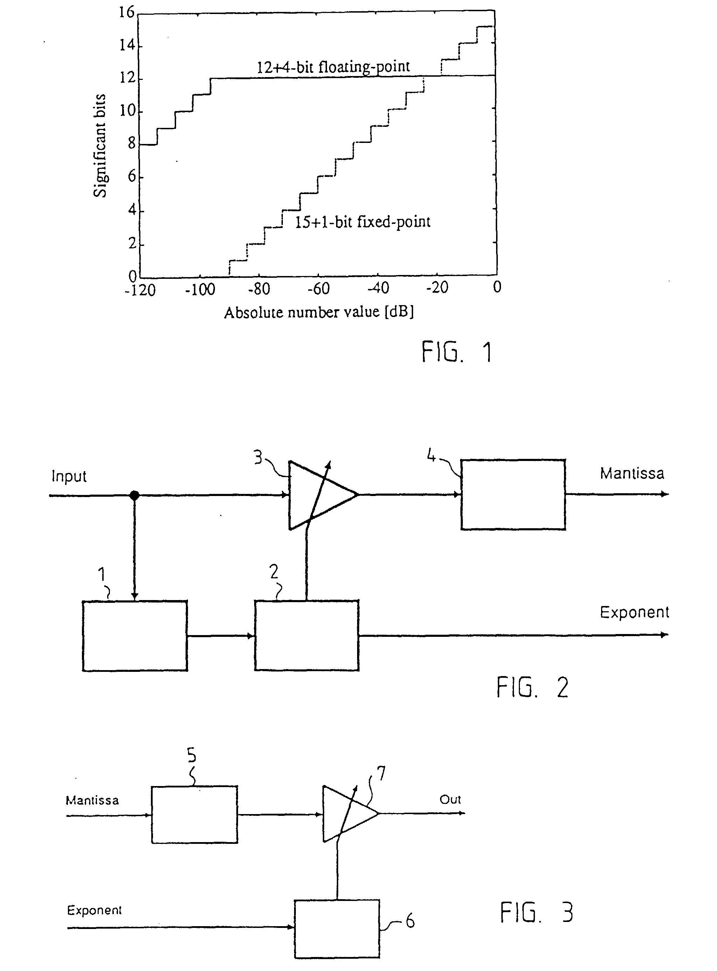

A floating-point number is a scaled number representation in which the exponent part functions as a scaling factor. Due to scaling, the word length of the whole mantissa is always in use in floating-point representation, which makes the floating-point representation so efficient. Fig. 1 shows a comparison between the relative accuracy of normalized floating-point representation and fixed-point representation (in significant bits) when the floating-point number consists of a 12-bit mantissa (sign included) and a 4-bit exponent and when the word length of fixed-point representation is 1+15 bits (one bit for the sign). As shown in Fig. 1, in floating-point representation the relative accuracy of number representation is a constant that is independent of the magnitude of the number within the dynamic range of the number representation. In fixed-point representation, the relative representation accuracy decreases as the number becomes smaller. In practice this means that with small numbers, the most significant bits are never in use in fixed-point representation. When the relative proportion of small sample values to all sample values is high, as usually e.g. in music and audio signals, a much greater accuracy in sample value representation with the same overall word length is achieved with floating-point representation.

The performance of A/D and D/A converters can be improved by utilizing floating point number representation. Conventionally, a floating-point A/D converter is implemented by a fixed-point A/D converter and an adjustable amplifier. A block diagram of the structure is shown in Fig. 2. The amplitude of the analog signal to be converted is measured by a measuring circuit 1, and the amplification of the adjustable amplifier is set by a control circuit 2 on the basis of the measurement such that it corresponds to the exponential term. The signal input to a fixed-point A/D converter corresponds to the mantissa of the signal to be sampled. The adjustable amplifier is usually adjusted in steps of 6 dB. As stated above, the drawbacks of the structure are that the analog unit is complicated and the converter structure is slow since the settling of the adjustable amplifier requires time.

A block diagram of a corresponding conventional floating-point D/A converter is shown in Fig. 3. The mantissa of the floating-point number is converted by a fixed-point D/A converter, and an amplifier 7 adjustable by a control circuit 6 is regulated by the exponent part.

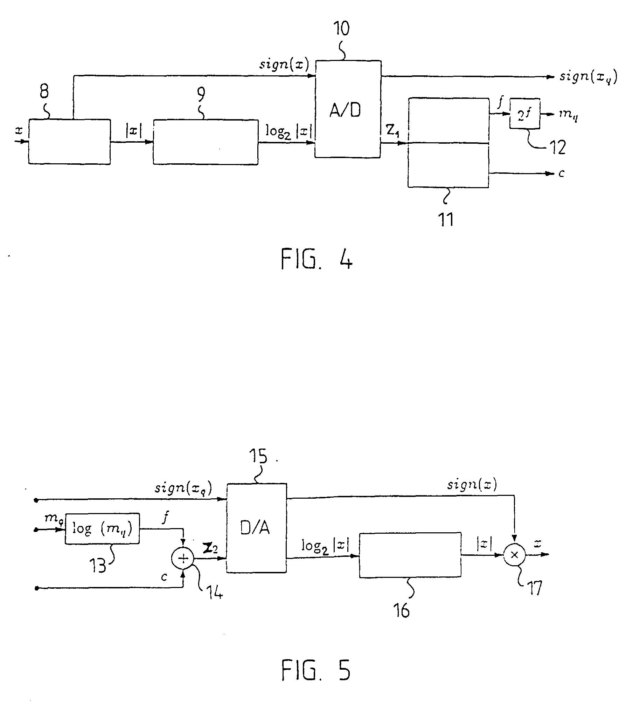

In the following the invention will be described in greater detail with reference to attached Figs. 4 to 7, in which

Fig. 4 shows a block diagram of a floating-point A/D converter according to the invention,
Fig. 5 shows a block diagram of a floating-point D/A converter according to the invention,

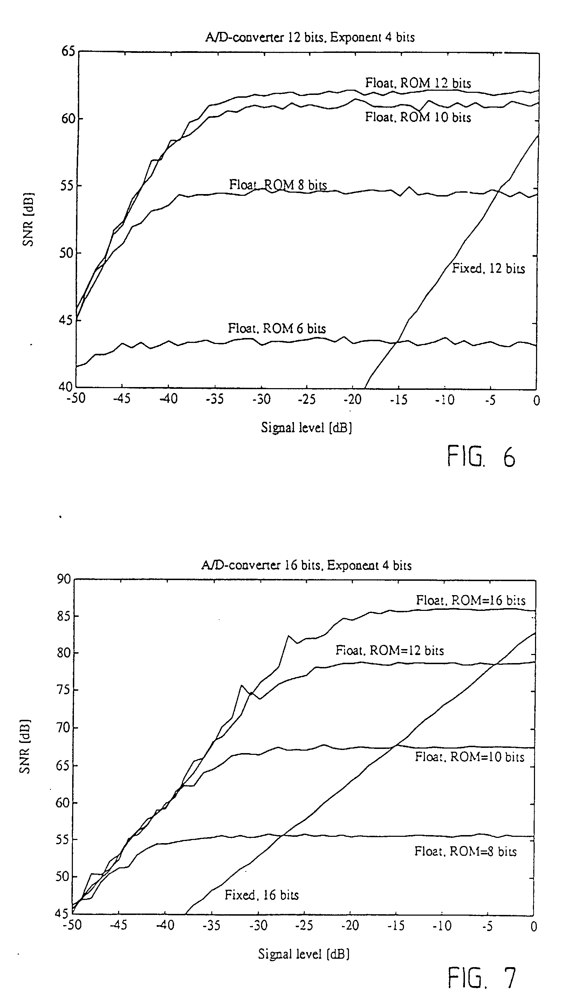

Figs. 6 and 7 show simulation results of a floating-point A/D converter according to Fig. 4 and a floating-point D/A converter according to Fig. 5 (signal-to-noise ratio as a function of the level of the signal to be converted).

The floating-point A/D converter according to the invention is implemented by the use of logarithmic non-linearity and a fixed-point A/D converter. A block diagram of the structure is shown in Fig. 4. The structure according to the block diagram utilizes the definition of the exponent of a floating-point number presented in equation (2). If the analog signal to be converted can have either polarity (+ and -), the sign (polarity) of the signal must be checked and separated in block 8. If the analog signal can only have one polarity, the polarity need not be checked. The same situation is achieved if the analog signal to be converted is biased such that the signal produced can only have one polarity. The added bias is removed in the digital unit when a floating-point number output from the converter is formed. After a possible separation of the sign, the analog signal is input to a block 9 that effects a base 2 logarithmic non-linearity. The base of the actual logarithmic conversion may be arbitrary since the base 2 logarithm needed is easy to obtain by multiplication by a constant, as shown by the equation below.

$$\log_2 y = \frac{\log_\beta y}{\log_\beta 2} \tag{3}$$

$\beta$ is an arbitrary base, and $1/\log_\beta 2$ is a constant coefficient. The logarithmed signal is input to a fixed-point A/D converter 10. A floating-point number is easy to obtain from the thus obtained sampled signal $z_1$ since the exponent c of the sample value is the integer part of the output of the A/D converter 10, i.e.

$$c = \lfloor z_1 \rfloor^+ 1 = \lfloor \log_2 |x| \rfloor + 1 \tag{4}$$

When the exponent has been separated in a block 11, the quantized mantissa $m_q$ of the sample value can be calculated from the remaining fractional part f

$$f = z_1 - \lfloor z_1 \rfloor - 1$$

$$m_q = (2^f)_q \tag{5}$$

The raise to a power of two is performed with the aid of a table in a ROM or RAM memory 12. The word length output from the memory corresponds to the word length output from the floating-point A/D converter.

The sample values converted by said floating-point A/D conversion method can be stored - in addition to the floating-point representation (sign, mantissa and exponent) - in fixed-point form. The use of sign/ magnitude representation in fixed-point representation renders the bit representation of a fixed-point number simple. The bit representation of the mantissa of a floating-point number is first placed in the most significant bits of the fixed-point representation. The mantissa is then transferred to the right by as many bits as the exponent of the number is smaller than the maximum exponent. The fixed-point number is finally obtained by adding the sign to the number. In order that the accuracy achieved with the floating-point conversion might not be lost in the conversion from a floating-point number to a fixed-point number, the word length of the fixed-point representation must be significantly greater than the word length of the mantissa of the floating-point representation. If the word length of the fixed-point representation is greater than $2^{b_c} - 1 + b_m$, in which $b_c$ is the word length of the exponent and $b_m$ is that of the mantissa, no significant bits are lost in the conversion.

Below is an example for a working floating-point A/D converter according to the invention. Let the convertible signal be unipolar, whereby the sign need not be taken into account nor separated. The easiest way of implementing logarithmic non-linearity is to use a logarithmic amplifier, which are generally available in different versions by various manufacturers of analog components. These amplifiers usually have a base of 10. A base 2 logarithm is obtained by placing an analog coefficient $1/\log_{10} 2$ after the logarithmic amplifier, i.e.

$$\log_2 y = \log_{10} y \cdot (1/\log_{10} 2) \tag{6}$$

A logarithmed signal is then input to a fixed-point A/D converter, whose resolution is e.g. 12 bits. If the dynamic range of the logarithmic amplifier is 96 dB, the number of the exponent bits in floating-point representation can be determined as 4. The exponent of a floating-point number is now obtained directly from the four most significant bits of the A/D converter, which here correspond to the integer part of the number in the logarithmic number representation. The mantissa of the floating-point number can be calculated from the eight remaining least significant bits. The mantissa can be calculated e.g. with the aid of the table in the RAM memory. If the desired word length of the mantissa is 12 bits, then $2^8 = 256$ possible values of the mantissa are presented in the table with the accuracy of 12 bits. A 12+4-bit floating-point A/D converter using a 12-bit A/D converter is simulated at the end of the present application.

A floating-point D/A converter according to the invention is implemented by the use of a fixed-point D/A converter and exponential non-linearity. Fig. 5 shows a block diagram of the structure. Said floating-point D/A conversion method utilizes the definition of a floating-point number in a similar manner as the floating-point A/D conversion method described above. The D/A convertible floating-point numbers are first divided into parts, i.e. the sign $\text{sign}(x_q)$, mantissa $m_q$ and exponent c. Also in the D/A conversion, biased representation can be used, whereby all the numbers have the same sign, which thus need not be taken into account in the actual conversion. The mantissa is converted to the exponent of two by extracting a base 2 logarithm thereof with the aid of the table in the ROM or RAM memory of a block 13. When the converted mantissa f and exponent c are added by a digital adder 14, a desired sampled signal $z_2$ is obtained. By conversion of said sampled digital signal to an analog signal $\log_2|x|$ by a fixed-point D/A converter 15, the logarithm of the desired output signal x is obtained. When this signal is input to a block 16 that effects an exponential non-linearity (base 2), the output is the amplitude of the converted signal. The base of the block effecting the actual exponential non-linearity may also be arbitrary since its effect can be compensated by multiplying the signal in the logarithmic base, prior to effecting the non-linearity, by a constant $\log_\beta 2$, as shown below.

$$y = 2^{\log_2 y} = \beta^{\log_\beta y} = \beta^{\log_2 y \log_\beta 2} \tag{7}$$

$\beta$ is an arbitrary base of the exponential function, $\log_\beta 2$ is a constant coefficient. When the sign or polarity is added to the signal in a block 17, if necessary, the result is the desired analog signal, which is the output of the floating-point D/A converter.

An example for a working floating-point D/A converter according to the invention is a structure corresponding to the floating-point A/D converter described above. Let all the numbers have the same sign, whereby the sign need not be taken into account. The mantissae of the floating-point numbers are first converted with the aid of the table in a RAM memory from 12-bit mantissae to 8-bit exponents of 2 by a base 2 logarithmic function. The eight thus obtained least significant bits of logarithmic number representation are added to the four most significant bits of the logarithmic number representation, i.e. the exponent bits of the floating-point number, to obtain a 12-bit number of logarithmic number representation. Said number is converted to an analog signal by a 12-bit fixed-point D/A converter. This analog signal is then input to a block effecting an exponential non-linearity. The easiest way of implementing the block is to use an exponential amplifier (also known as an antilogarithmic amplifier); such amplifiers are generally available in stores selling analog components. Exponential amplifiers often have a base of 10. A base 10 exponential amplifier can be easily converted to a base 2 amplifier suitable for the present purpose by multiplying the output constant of the D/A converter by an analog coefficient $\log_{10} 2$, i.e.

$$y = \beta^{\log_\beta y} \Rightarrow y = 10^{\log_{10} y} \Rightarrow \log_{10} y = \log_2 y \cdot \log_{10} 2 \tag{8}$$

The output of the exponential amplifier is here the output of the floating-point D/A converter.

In the above practical examples, the base 2 logarithmic and exponential non-linearities were effected by base 10 logarithmic and exponential amplifiers and a constant coefficient. Other simple ways of implementing these non-linearities include logarithmically and exponentially weighted resistor networks.

Error analysis of floating-point converter structures according to the invention

Since digital signal processing is possible only when the word length is finite, applications of signal processing always contain rounding errors caused by the finite word length. Therefore the word length to be used in the applications must be selected such that the rounding errors are not significant to the operation of the system.

The floating-point A/D converter according to Fig. 4 has three sources of error, i.e. the logarithmic non-linearity, the fixed-point A/D conversion and the calculation of the mantissa with the aid of a table (since an exponential function can be approximated only with the accuracy of the word length output from the table). Of these sources of error, the deviation of the logarithmic non-linearity block from the ideal logarithm can be compensated by modifying the table used for calculating the mantissa. In error analysis, the non-linearity block can thus be assumed to be ideal, whereby it is possible to concentrate on the properties of the finite word length caused by the A/D conversion and mantissa table.

The floating-point D/A converter according to Fig. 5 also has three sources of error, i.e. the table used for converting the mantissa to a power of two, the fixed-point D/A conversion and the exponential non-linearity. linearity. Also, the deviation of the exponential block from the ideal exponential function can be compensated by modifying the logarithmic function table, which is used as the mantissa is converted to a power of two. Thus the exponential non-linearity block can also be assumed to be ideal. When the non-linearity blocks are ideal, the error analyses of the A/D and D/A converter are identical. On account of this, only A/D converter error analysis is discussed below. The results obtained also apply to a D/A converter.

In analyzing the properties of finite word length in floating-point arithmetic, rounding errors are modelled by a relative error model. This error model is used because the emerging rounding errors are dependent on the exponent term due to the magnitude of the number to be rounded. The number $x_q$ indicating the finite word length is presented by the number $x$ indicating the infinite accuracy and by the relative rounding error $\varepsilon$

$$x_q = x \cdot (1+\varepsilon) \tag{9}$$

The rounding errors in the floating-point A/D converter can be presented by the relative error model. If the rounding error in fixed-point A/D conversion is indicated by $e_1$, then the output of the fixed-point A/D converter is

$$z_1 = (\log_2|x|)_q = \log_2|x| + e_1 \tag{10}$$

The effect of this source of error in the output of the floating-point converter is

$$x_q = sign(x)2^{z_1} = x \cdot 2^{e_1} \tag{11}$$

Using a series expansion of an exponential function, the equation may be written as

$$x_q = x \cdot 2^{e_1} = x \cdot \left[ 1 + e_1 \ln 2 + \frac{(e_1 \ln 2)^2}{2!} + \ldots + \frac{(e_1 \ln 2)^n}{n!} + \ldots \right] \tag{12}$$
$$= x \cdot (1 + \alpha)$$

If a quantizing error in the exponent table used for calculating the mantissa is indicated by $e_2$, then the quantized mantissa is

$$m_q = (2^f)_q = 2^f + e_2 \tag{13}$$

In the output of the converter, this quantizing error is seen as a normal relative quantizing error

$$x_q = x \cdot (1 + \beta) \Rightarrow \varepsilon = \frac{x_q - x}{x} = \frac{m_q - m}{m} = \frac{e_2}{m} \tag{14}$$

In floating-point arithmetic, the variance of the quantizing error can be shown to be

$$\sigma_{err}^2 = \sigma_x^2 \sigma_\varepsilon^2 \tag{15}$$

where $\sigma_x^2$ is the variance or power of a signal and $\sigma_\varepsilon^2$ is that of a relative quantizing error. In the floating-point A/D converter, the relative quantizing error as a whole is $\varepsilon = \alpha + \beta$. Since variables $\alpha$ and $\beta$ may independently be converted to stochastic variables, the variance of the relative quantizing error is here

$$\sigma_\varepsilon^2 = \sigma_\alpha^2 \sigma_\beta^2 \tag{16}$$

If the word length of a fixed-point A/D converter is $1 + b_i + b_f$ (one bit for the sign, $b_i$ bits for the integer part and $b_f$ bits for the fractional part), then the variance of $\alpha$ is

$$\sigma_\alpha^2 = \frac{\Delta_1^2 (\ln 2)^2}{12} = \frac{2^{-2b_f}(\ln 2)^2}{12} \tag{17}$$

$\Delta_1 = 2^{-b_f}$ is the quantization step of the A/D converter. If the word length of the output of the mantissa table is $b_m$ bits, then the variance of $\beta$ is

$$\sigma\beta^2 = \frac{\Delta_2^2}{8\ln 2} = \frac{2^{-2b_m}}{8\ln 2} \tag{18}$$

$\Delta_2 = 2^{-b_m}$ is the quantization step of the mantissa.

The signal-to-noise ratio (SNR) of the floating-point A/D converter according to the invention, on the assumption that the logarithmic non-linearity block is ideal, is

$$SNR = 10\log_{10} \frac{\sigma_x^2}{\sigma x^2 \sigma_\varepsilon^2} = 10\log_{10} \frac{1}{\sigma_\alpha^2 + \sigma_\beta^2} \tag{19}$$

The signal-to-noise ratio of the floating-point D/A converter according to the invention is as presented by the equation above, on the assumption that the exponential non-linearity is ideal.

The operation of the converter structures according to the invention was tested by simulating their operation by different parameters. The operation of the non-linearity blocks was assumed to be ideal. Since on this assumption, the A/D and D/A converters operate in a very similar manner, results for only floating-point A/D converters are presented here. Corresponding results apply to floating-point D/A converters.

First, theoretical signal-to-noise ratios were calculated for the converter structure from equation (19). The ratios are shown in Table 1. In the simulations and signal-to-noise ratio calculations a signal with a biexponentially divided amplitude was used as a quantizing signal since this probability distribution approximates very well e.g. to the amplitude distribution of music signals.

Table 1

| Theoretical signal-to-noise ratios calculated for different word lengths of fixed-point A/D converter and table (memory) | | | |
|---|---|---|---|
| A/D conversion (bits) | $b_i$ | table (bits) | SNR (dB) |
| 12 | 4 | 6 | 43.5 |
| 12 | 4 | 8 | 54.7 |
| 12 | 4 | 10 | 61.1 |
| 12 | 4 | 12 | 62.1 |
| 16 | 4 | 8 | 55.6 |
| 16 | 4 | 10 | 67.6 |
| 16 | 4 | 12 | 78.8 |
| 16 | 4 | 16 | 86.1 |

Figs. 6 and 7 show simulation results obtained by corresponding parameters as shown in Table 1 for working floating-point A/D converters. As can be seen, the simulation results correlate well with the calculated theoretical signal-to-noise ratios, i.e. the theoretical results give the SNR values of the converters in their dynamic area. The figures show it clearly how the performance of a floating-point A/D converter depends on the values of its parameters, i.e. the word length of the fixed-point A/D converter and the word length of the mantissa table in the memory. The word length $b_i$ of

the exponent was chosen to be four bits since this produced a sufficiently good result with a biexponentially divided signal. For the sake of comparison, Figs. 6 and 7 show only the performance of a fixed-point A/D converter, i.e. the signal-to-noise ratio as a function of the signal level. As can be seen from the figures, with a sufficiently great word length of the mantissa table, a floating-point A/D converter is always considerably better than a fixed-point converter.

## Claims

1. A method for converting an analog signal to a digital floating-point number, c**haracterized** by

   - forming a logarithmed signal (log |x| ) from an analog signal (x) by a logarithmic function having an arbitrary base and multiplying the signal by a compensating constant coefficient if the base of said logarithmic function is other than 2;
   - converting the resultant signal to digital form (z) by fixed-point A/D conversion;
   - separating the exponent (c) of the floating-point number from the digitized sample value and calculating the mantissa ($m_q$) of the floating-point number from the fractional part (f) by a base 2 exponential function;
   - forming a digital floating-point number by adding the mantissa and the exponent.

2. A method according to claim 1, **characterized** by separating the sign (sign(x)) from the analog signal (x) and forming a signed digital floating-point number by adding the sign to the mantissa ($m_q$) and exponent (c) after the A/D conversion.

3. A method for converting a digital floating-point number to an analog signal, **characterized** by

   - converting the mantissa ($m_q$) of the floating-point number by a logarithmic function having an arbitrary base to the exponent of the base and multiplying the exponent by a compensating constant coefficient if the base of said logarithmic function is other than 2;
   - adding the thus converted mantissa and exponent;
   - converting the digital number ($z_2$) obtained to an analog signal by fixed-point D/A conversion and forming from the converted signal a signal that represents its base 2 exponent.

4. A method according to claim 3, **characterized** by separating the sign (sign($x_q$) from the floating-point number, and forming a signed D/A converted analog signal by adding the sign (sign(x)) to the converted analog signal (x).

5. An apparatus for converting an analog signal to a digital floating-point number, **characterized** by comprising logarithming means (9) for calculating a logarithmic function for the analog signal (x), means (10) for sampling the signal into digital form, means (11) for separating the exponent of the floating-point number, i.e. the integer part (c), and the fractional part (f) of a number with a logarithmic base, and means (12) for calculating the mantissa ($m_q$) of the floating-point number from the fractional part (f) of the number with a logarithmic base.

6. An apparatus according to claim 5, **characterized** by further comprising means (8) for separating the sign (sign (x)) of the analog signal and for adding it to the formed digital floating-point number.

7. An apparatus for converting a floating-point number to an analog signal, **characterized** by comprising means (13) for converting the mantissa ($m_q$) of the floating-point number to a fractional part (f) of a number with a logarithmic base, means (14) for forming a number with a logarithmic base by adding the fractional part (f) and the integer part (c), i.e. the exponent of the floating-point number, means (15) for converting a digital floating-point number ($z_2$) with a logarithmic base to an analog signal, and means (16) for calculating a base 2 exponential function from the analog signal (log|x| ).

8. The apparatus according to claim 7, **characterized** by further comprising means (17) for adding the digital sign (sign(x)) obtained from the floating-point number to the analog signal (|x| ).

## Patentansprüche

1. Verfahren zum Umsetzen eines analogen Signals in eine digitale Gleitkommazahl,
   **gekennzeichnet durch**

- Bilden eines logarithmischen Signals (log |x|) aus einem analogen Signal (x) durch eine logarithmische Funktion mit einer willkürlichen Basis und Multiplizieren des Signals mit einem konstanten Ausgleichsfaktor, wenn die Basis der logarithmischen Funktion eine andere als 2 ist;
- Umsetzen des Ergebnissignals in eine digitale Form ($z_1$) durch eine Festpunkt-A/D-Umsetzung;
- Trennen des Exponenten (c) der Gleitkommazahl von dem digitalisierten Abtastwert und Berechnen der Mantisse ($m_q$) der Gleitkommazahl aus den Nachkommastellen (f) durch eine Exponentialfunktion mit der Basis 2;
- Bilden einer digitalen Gleitkommazahl durch Addieren der Mantisse und des Exponenten.

2. Verfahren nach Anspruch 1,
**gekennzeichnet durch**
Trennen des Vorzeichens (sign(x)) von dem analogen Signal (x) und Bilden einer digitalen vorzeichenbehafteten Gleitkommazahl durch Addieren des Vorzeichens zu der Mantisse ($m_q$) und dem Exponenten (c) nach der A/D-Umsetzung.

3. Verfahren zum Umsetzen einer digitalen Gleitkommazahl in ein analoges Signal,
**gekennzeichnet durch**

- Umsetzen der Mantisse (mq) der Gleitkommazahl durch eine logarithmische Funktion mit einer willkürlichen Basis zum Exponenten der Basis und Multiplizieren des Exponenten mit einem konstanten Ausgleichsfaktor, wenn die Basis der logarithmischen Funktion eine andere als 2 ist;
- Addieren der so umgesetzten Mantissen und des Exponenten;
- Umsetzen der erhaltenen digitalen Zahl ($z_2$) in ein analoges Signal durch eine Festpunkt-D/A-Umsetzung und Bilden eines Signals aus dem umgesetzten Signal, das seinen Exponenten zur Basis 2 darstellt.

4. Verfahren nach Anspruch 3,
**gekennzeichnet durch**
Trennen des Vorzeichens (sign($x_q$)) von der Gleitkommazahl und Bilden eines vorzeichenbehafteten D/A-umgesetzten analogen Signals durch Addieren des Vorzeichens (sign(x)) zu dem umgesetzten analogen Signal (x).

5. Vorrichtung zum Umsetzen eines analogen Signals in eine digitale Gleitkommazahl,
**gekennzeichnet durch**
eine Logarithmier-Einrichtung (9) zum Berechnen einer logarithmischen Funktion für das analoge Signal (x), eine Einrichtung (10) zum Umsetzen des Signals in eine digitale Form, eine Einrichtung (11) zum Trennen des Exponenten der Gleitkommazahl, d.h. des ganzzahligen Teiles (c), und der Nachkommastellen (t) einer Zahl mit einer logarithmischen Basis, und eine Einrichtung (12) zum Berechnen der Mantisse ($m_q$) der Gleitkommazahl aus den Nachkommastellen (f) der Zahl mit einer logarithmischen Basis.

6. Vorrichtung nach Anspruch 5,
**gekennzeichnet durch**
eine Einrichtung (8) zum Trennen des Vorzeichens (sign(x)) des analogen Signals und zum Addieren desselben zu der gebildeten digitalen Gleitkommazahl.

7. Vorrichtung zum Umsetzen einer Gleitkommazahl in ein analoges Signal,
**gekennzeichnet durch**
eine Einrichtung (13) zum Umsetzen der Mantisse ($m_q$) der Gleitkommazahl in die Nachkommastellen einer Zahl mit einer logarithmischen Basis, eine Einrichtung (14) zum Bilden einer Zahl mit einer logarithmischen Basis durch Addieren der Nachkommastellen (f) und des ganzzahligen Teiles (c), d.h. des Exponenten der Gleitkommazahl, eine Einrichtung zum Umsetzen einer digitalen Gleitkommazahl ($z_2$) mit einer logarithmischen Basis in ein analoges Signal, und eine Einrichtung (16) zum Berechnen einer Exponentialfunktion mit der Basis 2 aus dem analogen Signal (log |x|).

8. Vorrichtung nach Anspruch 7,
**gekennzeichnet durch**
eine Einrichtung (17) zum Addieren des von der Gleitkommazahl erhaltenen digitalen Vorzeichens (sign(x)) zu dem analogen Signal (|x|).

**Revendications**

1. Procédé pour convertir un signal analogique en un nombre numérique à virgule flottante, caractérisé par

   - formation d'un signal sous forme logarithmique (iog |x|) à partir d'un signal analogique (x) au moyen d'une fonction logarithmique ayant une base arbitraire, et multiplication du signal par un coefficient constant de compensation si la base de ladite fonction logarithmique est autre que 2;
   - conversion du signal résultant sous une forme numérique (z) au moyen d'une conversion analogique / numérique à virgule fixe;
   - séparation de l'exposant (c) du nombre à virgule flottante à partir de la valeur échantillon numérisée et calcul de la mantisse ($m_q$) du nombre à virgule flottante à partir de la partie fractionnaire (f) au moyen d'une fonction exponentielle à base 2;
   - formation d'un nombre numérique à virgule flottante par addition de la mantisse et de l'exposant.

2. Procédé selon la revendication 1, caractérisé par la séparation du signe (sign(x)) du signal analogique (x) et formation d'un nombre numérique à virgule flottante pourvue d'un signe, par addition du signe à la mantisse ($m_q$) et à l'exposant (c) après la conversion analogique / numérique.

3. Procédé pour convertir un nombre numérique à virgule flottante en un signal analogique, caractérisé par

   - conversion de la mantisse ($m_q$) du nombre à virgule flottante au moyen d'une fonction logarithmique ayant une base quelconque en l'exposant de la base et multiplication de l'exposant par un coefficient constant de compensation si la base de ladite fonction logarithmique est autre que 2;
   - addition de la mantisse ainsi convertie et de l'exposant;
   - conversion du nombre numérique ($z_2$) obtenu en un signal analogique par une conversion numérique / analogique à virgule fixe et formation, à partir du signal converti, d'un signal qui représente son exposant à base 2.

4. Procédé selon la revendication 3, caractérisé par séparation du signe (sign($x_q$)) du nombre à virgule flottante, et formation d'un signal analogique ayant subi la conversion numérique / analogique et pourvu d'un signe par addition du signe (sign(x)) au signal analogique converti (x).

5. Dispositif pour convertir un signal analogique en un nombre numérique à virgule flottante, caractérisé en ce qu'il comprend des moyens logarithmiques (9) pour calculer une fonction logarithmique pour le signal analogique (x), des moyens (10) pour échantillonner le signal sous une forme numérique et des moyens (11) pour séparer l'exposant du nombre à virgule flottante, c'est-à-dire la partie entière (c), et la partie fractionnaire (f) d'un nombre ayant une base logarithmique, et des moyens (12) pour calculer la mantisse ($m_q$) du nombre à virgule flottante à partir de la partie fractionnaire (f) du nombre à base logarithmique.

6. Dispositif selon la revendication 5, caractérisé en ce qu'il comporte en outre des moyens (8) pour séparer le signe (sign(x)) du signal analogique et pour l'ajouter au nombre numérique à virgule flottante formé.

7. Dispositif pour convertir un nombre à virgule flottante en un signal analogique, caractérisé en ce qu'il comporte des moyens (13) pour convertir la mantisse ($m_q$) du nombre à virgule flottante en une partie fractionnaire (f) d'un nombre ayant une base logarithmique, des moyens (14) pour former un nombre à base logarithmique par addition de la partie fractionnaire (f) et de la partie entière (c), c'est-à-dire de l'exposant du nombre à virgule flottante, des moyens (15) pour convertir un nombre numérique à virgule flottante ($z_2$) avec une base logarithmique en un signal analogique, et des moyens (16) pour calculer une fonction exponentielle à base 2 à partir du signal analogique (log|x|).

8. Dispositif selon la revendication 7, caractérisé en ce qu'il comporte en outre des moyens (17) pour ajouter le signe numérique (sign(x)) obtenu à partir du nombre à virgule flottante, au signal analogique (|x|).

FIG. 1

FIG. 2

FIG. 3

FIG. 4

FIG. 5

12

A/D-converter 12 bits, Exponent 4 bits

FIG. 6

A/D-converter 16 bits, Exponent 4 bits

FIG. 7